Europäisches Patentamt

European Patent Office

Office européen des brevets

(11) Publication number: **0 405 836 A2**

## EUROPEAN PATENT APPLICATION

(21) Application number: **90306774.2**

(22) Date of filing: **21.06.90**

(51) Int. Cl.⁵: **H03M 5/14, //G11B20/14**

(30) Priority: **28.06.89 US 373804**

(43) Date of publication of application:
**02.01.91 Bulletin 91/01**

(84) Designated Contracting States:
**AT BE CH DE DK ES FR GB GR IT LI LU NL SE**

(71) Applicant: **DIGITAL EQUIPMENT CORPORATION**
**146 Main Street**
Maynard, Massachusetts 01745(US)

(72) Inventor: **Weng, Lih-Jyh**
**6 Bicentennial Drive**
**Lexington, Massachusetts(US)**

(74) Representative: **Hale, Peter et al**
**Kilburn & Strode 30 John Streeteet**
**London WC1N 2DD(GB)**

(54) Data encoding and demodulation system.

(57) A data encoding system and method for selectively encoding, demodulating, synchronizing a demodulator uses the following d = 7, k = 2 code:

| DATA BITS | CODE WORDS |
|-----------|------------|
| 00 | 000X |
| 01 | 0100 |
| 10 | 100X |
| 011 | 10000X |
| 111 | 100100 |
| 0000 | 1000000X |

where X is a ONE if the last two bits of the preceding code word are both ZEROS and a ZERO otherwise, and the right-most bits are the first in time. The system encodes the data by encoding the first four bits of data to an eight-bit code word if the bits are all ZEROS and the last two bits of the previous code word are in a predetermined pattern. If the first four bits are not ZEROS the system encodes the first three data bits to form a six-bit code word if the first two bits are both ONES. Otherwise, the system encodes the first two data bits to form a four-bit code word. The system selects the code word which preserves the code limited run length.

EXAMINE THE NEXT
FOUR DATA BITS                    20

ARE THE FOUR BITS           22
ALL ZEROES?

YES

ARE THE LAST          28
TWO BITS OF
THE PRECEDING
CODE WORD 01?

NO

ARE THE FIRST TWO          24
BITS BOTH ONES?            YES

NO

ARE THE LAST          30
TWO BITS OF
THE PRECEDING
CODEWORD 00?

ENCODE THE FIRST          26
TWO BITS ACCORDING
TO CODEWORD CHART 1

ENCODE THE           36
FIRST THREE
BITS ACCORDING
TO CODEWORD
CHART 1

YES          32

ENCODE THE
FOUR BITS TO
THE 8-BIT
CODEWORD
10000001

ENCODE THE FOUR BITS          34
TO THE 8-BIT CODEWORD
10000000

STORE A COPY OF THE LAST          38
TWO BITS OF THE CODEWORD

FIG. 2

APPLY THE CODEWORD          40
TO THE DISK DRIVE

## DATA ENCODING AND DEMODULATION SYSTEM

The invention relates generally to the field of signal demodulation and more particularly to the encoding of data to facilitate demodulation of signals recorded on mass storage media, for example, signals used for storing data in a digital data processing system, to identify the digital data represented thereby.

Binary digital data is typically recorded on mass storage media as a pattern of transitions in a storage medium. For example, data on magnetic storage media is represented by changes of magnetic polarity, and data on optical storage media is represented by changes in reflectivity or transmissivity. The transition patterns correspond to digital data which has been encoded to facilitate recording. When a magnetic memory is read using a head which is inductively read, or an optical memory is read using an optical scanner, an analog signal is generated with relative positive and negative peaks or large and small signals corresponding to the transition pattern. The analog signal, which may be distorted by system noise and other influences, is then demodulated to extract the original transition pattern as faithfully as possible and interpret it as a series of binary encoded bits. The binary encoded bits must then be decoded to reproduce the original digital data.

Signal demodulation may become increasingly difficult as the density of data recorded on the disks is increased. With higher recording densities, the medium, or disk, space allotted for the recording of a transition signal, that is, a transition cell, is, in effect, reduced. The signals read from the transition cells tend to be smaller relative to the background noise as a result and they can be more readily misinterpreted.

The signals may be misinterpreted because of system noise, which can distort the signals read from the "small" transition cells, or because of interference from surrounding transition cells, which can cause signal peaks to shift either within a transition cell or even to adjacent transition cells. The misinterpretation of the transition signals results in errors in the binary encoded bits which, after decoding, results in errors in the digital data.

The need to encode data specifically to facilitate demodulation and minimize the effects of peak shifts, etc., is well known. One such encoding scheme is shown in United States Patent 4,146,909 to Beckenhaur et al., assigned to International Business Machines, Inc. (IBM). Data which may already be encoded for error correction is further encoded using a demodulation code, for example, the IBM code, before it is recorded on the storage medium. Thus the data is recorded in the form of a series of transitions corresponding to the demodulation code words.

When a user requests data from storage the demodulation code words corresponding to the data are retrieved; that is, an analog signal is produced from the stored transition pattern. The analog signal corresponding to the code words must then be demodulated. Demodulation of the code word signal requires first determining the binary values corresponding to the signal transitions, and thus, the bit values, and next, finding the beginnings of the code words and decoding them. The resulting data may then be further decoded, for example, for error correction, to reproduce the actual data.

In order to facilitate demodulation the data is encoded such that the effects of signal transitions on nearby transition cells, for example, peak shifts, in the data signal are minimized. The data is typically encoded using a code which separates consecutive binary ONES, which correspond to transition cells containing signal transitions or peaks, by a minimum of one or more binary ZEROS, which correspond to transition cells without signal transitions.

To further facilitate the determination of the bit values associated with the recorded signal, the data is encoded such that the data signal, which typically includes clock information which enables the demodulator to find and synchronize to the signal transition cells, has a limited number of consecutive binary ZEROS. A ZERO is represented by a transitionless cell, and thus, too many consecutive ZEROS may result in the demodulator losing clocking information. Codes having these limitations for both ONES and ZEROS are commonly referred to as "run-length-limited" codes.

The IBM code discussed above is a run-length-limited code which separates consecutive ONES in a code word by at least two ZEROS. The parameter d is commonly associated with this minimum number of ZEROS, and thus, $d = 2$. The IBM code allows at most seven consecutive ZEROS. The parameter k is commonly associated with the maximum number of ZEROS, and thus, $k = 7$. Codes for which d and k are both small numbers and relatively close to each other are best suited for demodulation encoding.

The IBM code using these d and k parameters encodes groups of two, three and four data bits into any of seven code words, but does not offer an advantageous code-rate, i.e., the ratio of total number of data bits, to the total number of encoded bits; nor does it offer a higher information content for each flux reversal. The number of valid code words in a code determines the complexity of the corresponding encoder and demodulator. Thus codes which contain fewer code words may use less complex encoders and de-

EP 0 405 836 A2

modulators.

It is desirable to improve the d = 2, k = 7 modulation code further. The present invention approaches the problem by using novel decoding and a code rate of 1/2; i.e., every data bit is mapped to two encoded bits.

The invention comprises a data storage system including an encoder and a demodulator which encodes and demodulates data, respectively, using an improved d = 2, k = 7 demodulation code. The encoder encodes one data bit to two code word bits, and thus, the code rate is 1/2.

The invention in its broad form resides in a system and a method for encoding data including the step of encoding data by using the following code:

| DATA BITS | CODE WORDS |
|---|---|
| 00 | 000X |
| 01 | 0100 |
| 10 | 100X |
| 011 | 10000X |
| 111 | 100100 |
| 0000 | 10000001 |

where X is a ONE if the last two bits of the preceding code word are both ZEROS and X is a ZERO otherwise, and the right-most bits of the data and the code words are the first in time.

Alternatively, the encoder of the system encodes data to form any of six possible code words according to the following code word chart:

CHART 1

| DATA BITS | CODE WORDS |
|---|---|
| 00 | 000X |
| 01 | 0100 |
| 10 | 100X |
| 011 | 10000X |
| 111 | 100100 |
| 0000 | 1000000X |

where X is a ONE if the last two bits of the preceding code word are both ZEROS and X is a ZERO otherwise, and the right-most bits of the data and the code words are the first in time.

Other aspects and features of the invention are defined in the accompanying claims to which reference is hereby made.

The invention also extends to a method for storing data in a storage medium including applying the data encoded as a run length limited code, according to the encoding methods defined in the claims, to the storage medium.

In this regard, the invention extends to a method of retrieving data stored as a run length limited code in a storage medium including demodulating the data in accordance with the demodulating methods defined in the claims.

The invention further extends to a system for storing encoded data in a storage medium including means for applying the data encoded by the encoding systems, defined in the claims, to the storage medium.

This aspect of the invention also extends to a system for retrieving encoded data from a storage medium including means for reading the encoded data and means for demodulating the encoded data in accordance with the demodulating systems defined in the claims.

First, an encoder examines four incoming data bits. If the four bits are all ZEROS the encoder next examines the last two bits of the previous code word to determine if the bits are 01. If they are, the encoder encodes the first two of the four ZERO bits to form one of the four-bit code words in the Chart 1 above. The

4

encoder selects the four bit code word which preserves the limited run length, and thus, it selects 0000. Otherwise, the encoder encodes the four ZERO bits to form one of the two eight-bit code words in the code word Chart 1 above. The encoder selects the eight-bit code word which preserves the limited run length of the code. For example, if the two previous bits are 00 the encoder selects 10000001.

If the four data bits are not all ZEROS, the encoder next examines just the first two data bits. If these bits are both ONES the encoder encodes the two data bits along with the third data bit to form a six-bit code word according to the chart. Otherwise, the encoder encodes the first two data bits to form a four-bit code word according to the chart.

After these data bits are encoded, the encoder applies the code word to storage, for example, a disk drive, where it is stored for future use. The encoder also retains a copy of the last two bits of the code word. The encoder then continues to encode any incoming data according to the chart and applying it to the disk.

When data is requested from storage, the code words corresponding to the data, that is, the recorded signals, are retrieved from the disk. The data signal is then applied to a demodulator. The demodulator synchronizes to the signal, assigns bit values to it, and then attempts to decode code words. Specifically, it first attempts to decode the first eight bits of the encoded data. It sets the first two encoded bits to ZEROS and then compares the eight bits, two of which are set to ZERO, to the valid code word 10000000. If the encoded data bits match a code word the code word decodes to four data ZEROS. Otherwise, the demodulator attempts to decode the first six bits to three data bits and if this fails it decodes the first four bits to two data bits. If the code word bits can not be decoded according to the chart an error is declared for the first two data bits.

The invention may be better understood by referring to the following description of a preferred embodiment, given by way of example, and to be studied in conjunction with the accompanying drawings, in which:

Figure 1 is a block diagram of an encoding and demodulation system;

Figure 2 is a flow chart of the operations of an encoder encoding data in accordance with a preferred embodiment the invention; and

Figure 3 is a flow chart of the operations of a demodulator decoding the encoded data.

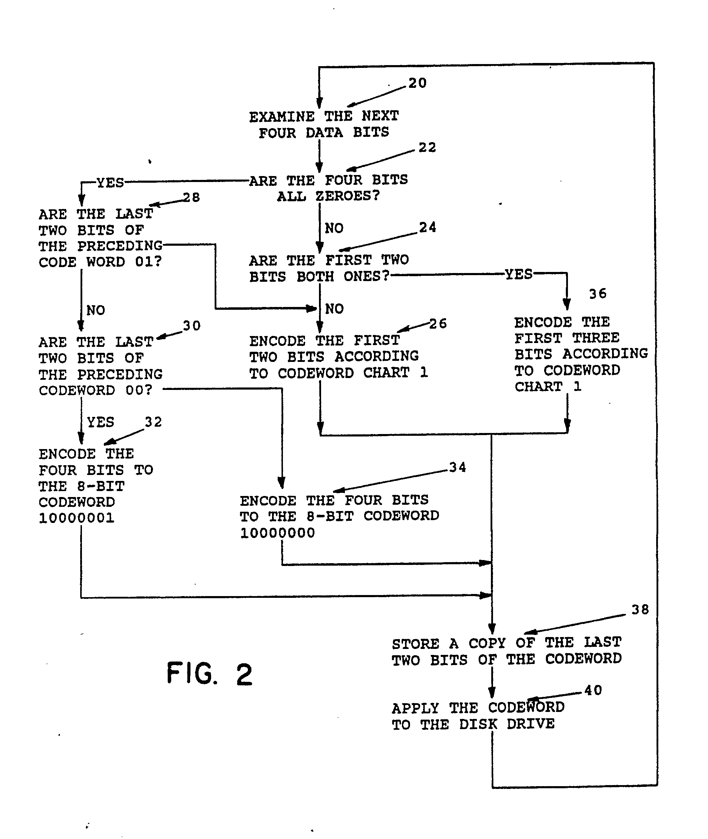

A data storage and retrieval system 10 includes an encoder 12, storage 16, for example, a disk drive, and a demodulator 18. The encoder 12 receives from a data bus 11 data bits which may have already been encoded for error correction purposes. The encoder further encodes the data bits into a code word using a $d = 2$, $k = 7$ code designed to facilitate demodulation, as discussed below with reference to Figure 2. The encoder then applies the code word to the disk drive 16. The encoder also retains in a buffer 12A a copy of the last two bits of the code word.

When the encoder 12 encodes the next few data bits it examines the retained bits and selects a code word for the data which preserves the limited run length ($d = 2$, $k = 7$) of the code. Once the encoder 12 has encoded the data the disk drive 16 stores the code words on, for example, a magnetic disk as a series of signal transitions, i.e., a series of flux reversals.

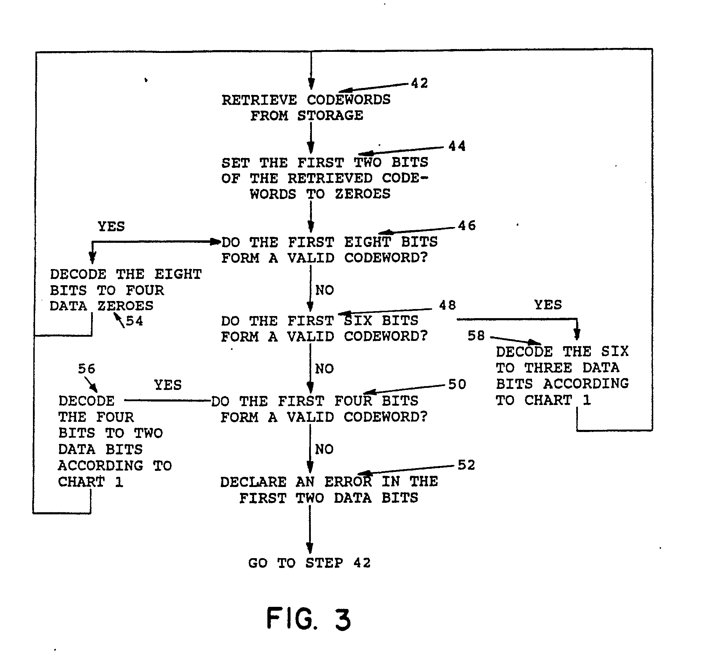

When a user requests stored data a data request signal 14 is sent to the disk drive 16. The drive 16 retrieves from the magnetic disk the signal corresponding to the data and applies the signal to the demodulator 18. The demodulator 18 synchronizes to the signal and assigns binary bit values to it. The demodulator 18 next decodes the data, if possible, as discussed below with reference to Figure 3. The demodulated data may be applied to an error correction decoder (not shown) for further decoding and correction, as appropriate.

To encode the incoming data the encoder 12 uses the code words set forth in Chart 1 below:

CHART 1

| DATA BITS | CODE WORDS |
|---|---|
| 00 | 000X |
| 01 | 0100 |
| 10 | 100X |
| 011 | 10000X |
| 111 | 100100 |
| 0000 | 1000000X |

where X is a ONE if the last two bits of the preceding code word are both ZEROS and X is a ZERO otherwise, and the right-most bits of the data and the code words are the first in time.

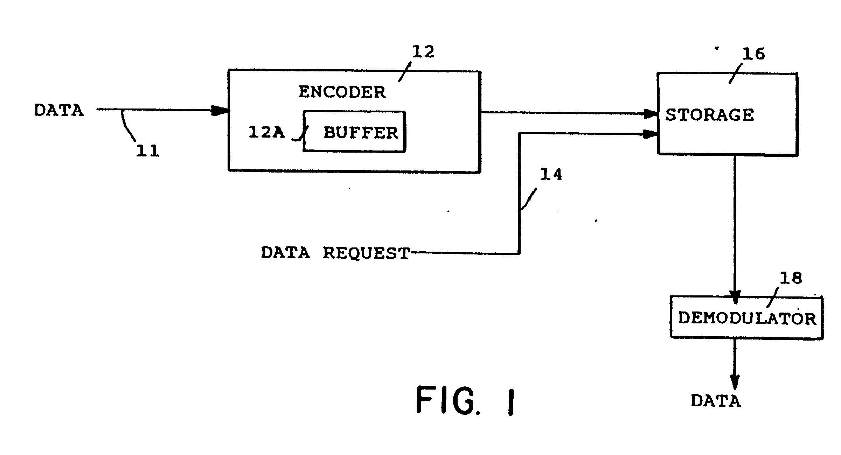

With reference to Figure 2, the encoder 12 examines the next four incoming data bits to determine if all the bits are ZEROS (steps 20-22). If the bits are all ZEROS the encoder 12 examines the last two bits of the previous code word stored in buffer 12A (Figure 1). Unless the two stored bits are 01, the encoder 12 encodes the four ZERO bits into an eight-bit code word which preserves the limited run- length of the code (steps 28-34). Thus, if the stored bits are both ZEROS, the encoder encodes the data bits to form the code word 10000001 to avoid too many consecutive ZEROS (steps 30-32). If the stored bits are 10 the encoder encodes the data bits to form the code word 10000000 to avoid consecutive ONES (steps 30, 34). If the stored bits are 01 the encoder encodes the first two of the four ZERO bits to form a four-bit code word 0000 (step 26).

If the four data bits are not all ZEROS the encoder examines the first two data bits to determine if they are both ONES (step 24). If they are, the encoder encodes these two data bits and the next one to form a six-bit code word according to Chart 1 (step 36). For example, if the third data bit is a ONE the encoder 12 encodes the three data bits, 111, to form the code word 100100.

If the first two incoming data bits are not both ONES the encoder encodes the two data bits to form a four-bit code word according to Chart 1 (step 26). For example, the two data bits may be 01 and the encoder produces the corresponding code word 0100.

After the encoder formulates a code word it applies the code word to the disk drive 16. The encoder also retains a copy of the last two bits of the code word in buffer 12A (steps 38-40).

The encoder 12 then examines the next four data bits which have not yet been encoded. For example, if the encoder first examines four bits, b4, b3, b2, b1, and encodes the first two data bits b2 and b1 to form a four-bit code word, the encoder next examines the two bits which have not yet been encoded, bits b4 and b3, along with the next two incoming data bits, bits b5 and b6. If the encoder encodes these four examined data bits b6, b5, b4, and b3 to a code word, it then examines the next four incoming data bits b10, b9, b8, and b7 to determine if these bits are all ZEROS. Thus the encoder encodes the following data bits:

01 00 00 00 00 00 00 01 00 00 10 00 01

where the right-most bit is the first incoming data bit, to form the code words:

0100 0000 1000 0000 1000 0001 0000 0100 1000 0000 1001 0000 0100 where the underlined code words are the eight-bit code words corresponding to four all ZERO data bits. Referring now to Figure 3, when a data request 14 arrives at the disk drive 16, the disk drive 16 retrieves from the magnetic disk the signal corresponding to the data (step 42). The disk drive then sends the retrieved signal to the demodulator 18. The demodulator 18 assigns bit values to the signal and then attempts to decode the bits as code words. To decode the code words, the demodulator 18 sets the first two retrieved bits to ZEROS and then attempts to decode the first eight, six or four bits to four, three or two data bits, as set forth below (steps 44-46).

The decoder sets the first two bits to ZEROS to force to a given format a code word which includes an "X" set to a ONE, for example, 0001 for data bits 00. The value of the "X" term does not add any information to the code word, it simply preserves the desired limited run length. Thus setting the first two bits to ZEROS, and thereby forcing the X terms to ZEROS, simplifies the demodulator 18 by limiting the number of code words which the demodulator 18 must recognize.

The demodulator 18 compares the first eight bits, including the two set to ZEROS, with the eight-bit code word 10000000 shown in Chart 1. If the bits match the code word the demodulator decodes the bits as four data ZEROS (step 54).

If the eight bits do not match the code word, the demodulator 18 compares the first six bits, including the two bits set to ZEROS, with the two valid six-bit code words shown in Chart 1. If the bits match one of the code words the demodulator 18 decodes the code word to the corresponding three data bits (steps 48, 58). Otherwise, the demodulator 18 attempts to decode the first four bits, again including the two bits set to ZEROS, to two data bits according to Chart 1 (steps 50, 56). If the four retrieved bits do not form a valid code word the demodulator 18 declares a detected error in the first two data bits (step 52).

The demodulator 18 easily decodes four-bit code words to two data bits by assigning the data bits the values of the two most significant bits of the four bit code word. Thus the code word 0100 decodes to 01.

Once the demodulator has decoded a first code word or declared the first two bits erroneous, it examines the next eight encoded bits, sets the first two to ZEROS and attempts to decode them to four data bits, and so forth, until all the code words corresponding to the requested data have been decoded.

In order to ensure that the bits which are examined for decoding are bits at the start of a code word rather than bits in the middle of a code word, the demodulator 18 first examines the placement of the ZEROS and ONES in the first few retrieved bits. The demodulator 18 finds the beginning of a code word when it finds a ONE in bit position bo, o being an odd number, which is followed by three or more ZEROS. Similarly, it finds the beginning of a code word if it finds, starting at a bit position bo, either of two eight-bit patterns:

00000100 or 01000100.

The demodulator 18 may instead find the end of a code word by finding a ONE in bit position be, where e is an even number. The demodulator 18 determines that a particular bit is in an even or odd bit position based on information in the corresponding clock signal, in a manner which is well known to those skilled in the art.

If the demodulator 18 finds a repeated pattern of 0001 in the retrieved data with the ONE in a location corresponding to an odd bit position, the demodulator 18 determines that the retrieved sequence is shifted two bit positions, that is, that the sequence is advanced or delayed by two bits. Thus the demodulator advances two encoded bits to ensure that the pattern 0100 is the repeated one and the demodulation is thus synchronized to the data. It is rare that a properly functioning demodulator advances or delays data by an odd number of bits.

The encoder 12 and the demodulator 18 may encode and decode data using a second code word chart, as set forth below:

CHART 2

| DATA BITS | CODE WORDS |
|---|---|
| 00 | 000X |
| 01 | 0100 |
| 10 | 100X |
| 011 | 10000X |
| 111 | 100100 |
| 0000 | 10000001 |

where X is a ONE if the last two bits of the preceding code word are both ZEROS and X is a ZERO otherwise, and the right-most bits of the data and the code words are the first in time.

The only difference between this code and the code shown in Chart 1 is that there is only one valid eight-bit code word. The four data ZEROS are encoded to the eight-bit code word only if the last two bits of the previous code word are ZEROS. Otherwise, the first two ZERO bits are encoded to 0000.

Using the demodulation codes set forth above, a demodulator easily determines the binary values associated with ananalog data signal. The code is well suited to synchronizing the demodulator to the signal because it encodes a stream of data ZEROS to code words which preserve the desired limited run-length. It also facilitates synchronization of the demodulator to the beginnings or endings of codewords by encoding the data to code words with ONES in particular, that is, even or odd, bit positions. In addition, the encoder and demodulator required for the code may be less complex than those used in prior art systems because the present code has only six valid code words.

The foregoing description has been limited to two specific embodiments of this invention. It will be apparent, however, that variations and modifications may be made to the invention, with the attainment of some or all of the advantages of the invention. Therefore, it is the object of the appended claims to cover all such variations and modifications as come within the true scope of the invention.

**Claims**

1. A method for encoding data including the step of encoding data by using the following code:

| DATA BITS | CODE WORDS |
|-----------|------------|
| 00 | 000X |
| 01 | 0100 |
| 10 | 100X |
| 011 | 10000X |
| 111 | 100100 |
| 0000 | 1000000X |

where X is a ONE if the last two bits of the preceding code word are both ZEROS and X is a ZERO otherwise, and the right-most bits of the data and the code words are the first in time.

2. The data encoding method of claim 1, wherein said method further includes the steps of:

A. examining four data bits to determine if the bits are all ZEROS;

B1. if the bits are all ZEROS, examining the last two bits of a previous code word to determine if the two bits are in a predetermined pattern;

B2. if the two bits of the previous code word are not in the predetermined pattern, encoding the four ZERO bits to form an eight-bit code word in accordance with the code;

B3. if the two bits of the previous code word are in the predetermined pattern, encoding the first two ZERO bits to form a four-bit code word in accordance with the code;

C. if the four data bits are not all ZEROS, examining the first two data bits to determine if the bits are both ONES;

D1. if the two data bits are both ONES, encoding the first three data bits to form a six-bit code word in accordance with the code;

D2. if the two data bits are not both ONES, encoding the first two data bits to form a four-bit code word in accordance with the code; and

E. repeating steps A-D until all the data is encoded.

3. The data encoding method of claim 2, wherein said step of examining the last two bits of the previous code word further comprises determining if the bits match the pattern 01.

4. The data encoding method of claim 3, wherein said step of encoding the four ZERO bits to form an eight-bit code word comprises the steps of:

A. examining the two bits from the previous code word to determine if they are both ZEROS;

B. if the two bits from the previous code word are both ZEROS, encoding the four ZERO bits to form the code word 10000001; and

C. if the two bits from the previous code word are not both ZEROS, encoding the four ZERO bits to form the code word 10000000.

5. A method for encoding data including the step of encoding data by using the following code:

| DATA BITS | CODE WORDS |
|-----------|------------|
| 00 | 000X |
| 01 | 0100 |
| 10 | 100X |
| 011 | 10000X |
| 111 | 100100 |
| 0000 | 10000001 |

where X is a ONE if the last two bits of the preceding code word are both ZEROS and X is a ZERO otherwise, and the right-most bits of the data and the code words are the first in time.

6. The data encoding method of claim 5, wherein said method further includes the steps of:

A. examining four data bits to determine if the bits are all ZEROS;

B1. if the bits are all ZEROS, examining two bits of a previous code word to determine if the two bits are in a predetermined pattern;

B2. if the two bits from the previous code word are in the predetermined pattern, encoding the four ZERO bits to form an eight-bit code word;

B3. if the two bits from the previous code word are not in the predetermined pattern, encoding the first two ZERO bits to form a four-bit code word in accordance with the code;

C. if the four data bits are not all ZEROS, examining the first two data bits to determine if the bits are both ONES;

D1. if the two data bits are both ONES, encoding the first three data bits to form a six-bit code word in accordance with the code;

D2. if the two data bits are not both ONES, encoding the first two data bits to form a four-bit code word in accordance with the code; and

E. repeating steps A-D until all the data is encoded.

7. The data encoding method of claim 6, wherein said step of examining the last two encoded bits of a previous code word further includes determining if the bits match the pattern 00.

8. A method of demodulating data encoded by the following code:

| DATA BITS | CODE WORDS |
|---|---|
| 00 | 000X |
| 01 | 0100 |
| 10 | 100X |
| 011 | 10000X |
| 111 | 100100 |
| 0000 | 1000000X |

where X is a ONE if the last two bits of the preceding code word are both ZEROS and X is a ZERO otherwise, and the right-most bits of the data and the code words are the first in time, said method including the steps of:

A. setting the first two bits of the encoded data to ZEROS;

B1. comparing the first eight bits of the encoded data with the eight-bit code word 10000001;

B2. if the eight encoded bits match the code word, decoding the eight bits to the data bits corresponding to the code word;

C1. if the eight encoded bits do not match a code word, comparing the first six encoded bits with the valid six-bit code words;

C2. if the first six encoded bits match a code word, decoding the six bits to the data bits corresponding to the code word;

D1. if the six encoded bits do not match a code word, comparing the first four encoded bits with the valid four- bit code words;

D2. if the first four encoded bits match a code word, decoding the four encoded bits to the data bits corresponding to the code word; and

E. if the first four encoded bits do not match a code word, providing an error indicator signifying an error in the first two data bits.

9. The demodulating method of claim 8, wherein said method further includes the step of synchronizing to the beginnings of code words, said synchronizing step including determining the beginning of a code word by finding at least one of the following in the encoded data:

A. a single bit pattern of a ONE in an odd bit position followed by three ZEROS;

B. a ONE in an odd bit position followed by four or more ZEROS;

C. a bit pattern 00000100 starting at an odd bit position; or

D. a bit pattern 01000100 starting at an odd bit position.

10. The demodulating method of claim 9, wherein said synchronizing step further includes:

A. finding in the encoded data a repeated bit pattern of 0001 with the ONE in an odd bit position;

B. shifting two bit positions such that the repeated pattern is interpreted as 0100; and

C. finding in the shifted data a ONE in a predetermined bit position or a predetermined pattern signifying the beginning of a code word.

11. The demodulating method of claim 10, wherein said method further includes the step of determining the end of a code word by finding in the encoded data a ONE in an even bit position.

12. A data encoding system including a data encoder which encodes data by using the following code:

| DATA BITS | CODE WORDS |
|-----------|------------|
| 00 | 000X |
| 01 | 0100 |
| 10 | 100X |
| 011 | 10000X |
| 111 | 100100 |
| 0000 | 1000000X |

where X is a ONE if the last two bits of the preceding code word are both ZEROS and X is a ZERO otherwise, and the right-most bits of the data and the code words are the first in time.

13. The data encoding system of Claim 12, wherein said encoder includes:

A. means for examining the next four data bits;

B. encoding means for encoding the data bits, said encoding means including:

i. means for comparing two bits of a previous code word to a predetermined pattern if the four data bits are all ZEROS,

ii. first means for encoding the four ZERO bits to form an eight-bit code word in accordance with the code if the two bits of the previous code word are not in the predetermined pattern, said encoding means encoding the first two ZERO bits to form a four-bit code word in accordance with thecode if the two bits from the previous code word are in the predetermined pattern; and

iii. second means for encoding the first three data bits to form a six-bit code word in accordance with the code if the first two data bits are ONES, said encoding means encoding the first two data bits to form a four-bit code word if the two data bits are not both ONES.

14. The data encoding system of claim 13, wherein the predetermined pattern to which said comparing means compares the two encoded bits is the pattern 01.

15. The data encoding system of claim 14, wherein said first means for encoding includes means for encoding the four ZERO bits to 10000001 if the two bits of the previous code word are ZEROS, said encoding means encoding the four ZERO bits to 10000000 if the two bits are 10.

16. A data encoding system including a data encoder which encodes data by using the following code:

| DATA BITS | CODE WORDS |
|-----------|------------|
| 00 | 000X |
| 01 | 0100 |
| 10 | 100X |
| 011 | 10000X |
| 111 | 100100 |
| 0000 | 10000001 |

where X is a ONE if the last two bits of the preceding code word are both ZEROS and X is a ZERO otherwise, and the right-most bits of the data and the code words are the first in time.

17. The data encoding system of claim 16, wherein said encoder further includes:

A. means for examining the next four data bits;

B. encoding means for encoding the data bits, said encoding means including:

i. means for comparing two bits of a previous code word to a predetermined pattern if the data bits are all ZEROS;

ii. means for encoding, the four ZERO bits to form an eight-bit code word, if the two bits of the previous code word are in the predetermined pattern, said encoding means encoding the first two ZERO bits to form a four-bit code word in accordance with the code if the two bits are not in the predetermined pattern; and

iii. means for encoding the first three data bits to form a six-bit code word in accordance with the code if the first two of the data bits are ONES, said encoding means encoding the first two data bits to form a four-bit code word in accordance with the code if the two data bits are not both ONES.

18. The data encoding system of claim 17, wherein the predetermined pattern to which said comparing means compares the two encoded bits is the pattern 00.

19. A data demodulating system, said system including a decoder which decodes data encoded by the following code:

| DATA BITS | CODE WORDS |
| --- | --- |
| 00 | 000X |
| 01 | 0100 |
| 10 | 100X |
| 011 | 10000X |
| 111 | 100100 |
| 0000 | 1000000X |

where X is a ONE if the last two bits of the preceding code word are both ZEROS and X is a ZERO otherwise, and the right-most bits of the data and the code words are the first in time.

20. The data demodulating system of claim 19, wherein said decoder includes:

A. means for setting the first two bits of the encoded data to ZEROS;

B. means for comparing the first eight bits of the encoded data with the valid eight-bit code word;

C. means for decoding the bits to the corresponding data bits if the bits match the code word; and

D. means for detecting an error if the encoded bits do not match a code word.

21. The data demodulating system of claim 20, wherein said comparing and decoding means include:

A1. means for comparing the first six encoded bits with the valid six-bit code words if the eight encoded bits do not match a code word;

A2. means for decoding the six bits to the data bits corresponding to the code word if the first six encoded bits match a code word;

B1. means for comparing the first four encoded bits with the valid four-bit code words if the six encoded bits do not match a code word; and

B2. means for decoding the four encoded bits to the data bits corresponding to the code word if the first four encoded bits match a code word.

22. The data demodulating system of claim 21, wherein said comparing and decoding means further include means for signaling an error if the encoded bits do not match a code word.

23. The data demodulating system of claim 21, wherein said system further includes synchronization means for determining the beginnings of code words by finding in the encoded data at least one of the following:

A. a single bit pattern of a ONE in an odd bit position followed by three ZEROS;

B. a ONE in an odd bit position followed by four or more ZEROS;

C. a bit pattern 00000100 starting at an odd bit position; or

D. a bit pattern 01000100 starting at an odd bit position.

24. The data demodulating system of claim 23, wherein said synchronization means further includes:

A. finding in the encoded data a repeated bit pattern of 0001 with the ONE in an odd bit position;

B. means for shifting two bit positions such that the repeated pattern is interpreted as 0100; said synchronization means determining the beginning of a code word by finding in the shifted encoded data a ONE in a predetermined bit position or a predetermined bit pattern.

25. The data demodulating system of claim 24, wherein said system further includes means for determining the end of a code word by finding a ONE in an even bit position.

26. A data demodulating system, said system including a decoder which decodes data encoded using the following code:

| DATA BITS | CODE WORDS |
|-----------|------------|
| 00 | 000X |
| 01 | 0100 |
| 10 | 100X |
| 011 | 10000X |
| 111 | 100100 |
| 0000 | 10000001 |

where X is a ONE if the last two bits of the preceding code word are both ZEROS and X is a ZERO otherwise, and the right-most bits of the data and the code words are the first in time.

27. The data demodulating system of claim 26, wherein said decoder includes:

A. means for setting the first two bits of the encoded data to ZEROS;

B. means for comparing the first eight bits of the encoded data with the valid eight-bit, six-bit and four-bit code words;

C. means for decoding the bits to the corresponding data bits if the bits match a code word; and

D. means for detecting an error if the encoded bits do not match a code word.

28. The data demodulating system of claim 27, wherein said system includes means for determining the end of a code word by finding in the encoded data a ONE in an even bit position.

29. The data demodulating system of claim 28, wherein said system further includes synchronizing means for determining the beginnings of code words by finding in the encoded data at least one of the following:

A. a single bit pattern of a ONE in an odd bit position followed by three ZEROS;

B. a ONE in an odd bit position followed by four or more ZEROS;

C. a bit pattern 00000100 starting at an odd bit position; or

D. a bit pattern 01000100 starting at an odd bit position.

30. The data demodulating system of claim 28, wherein said synchronization means further includes:

A. means for finding in the encoded data a repeated bit pattern of 0001 with the ONE in an odd bit position;

B. means for shifting two bit positions such that the repeated pattern is interpreted as 0100; said synchronization means determining the beginning of a code word by finding in the shifted encoded data a ONE in a predetermined bit position or a predetermined bit pattern.

31. A method of demodulating data encoded by the following code:

| DATA BITS | CODE WORDS |
|-----------|------------|
| 00 | 000X |
| 01 | 0100 |
| 10 | 100X |
| 011 | 10000X |
| 111 | 100100 |
| 0000 | 10000001 |

where X is a ONE if the last two bits of the preceding code word are both ZEROS and X is a ZERO otherwise, and the right-most bits of the data and the code words are the first in time, said method including the steps of:

A. setting the first two bits of the encoded data to ZEROS;

B1. comparing the first eight bits of the encoded data with the eight-bit code word 10000001;

B2. if the eight encoded bits match the code word, decoding the eight bits to the data bits corresponding to the code word;

C1. if the eight encoded bits do not match a code word, comparing the first six encoded bits with the valid six-bit code words;

C2. if the first six encoded bits match a code word, decoding the six bits to the data bits corresponding to the code word;

D1. if the six encoded bits do not match a code word, comparing the first four encoded bits with the valid four- bit code words;

D2. if the first four encoded bits match a code word, decoding the four encoded bits to the data bits corresponding to the code word; and

E. if the first four encoded bits do not match a codeword, providing an error indicator signifying an error in the first two data bits.

32. The demodulating method of claim 31, wherein said method further includes the step of synchronizing to the beginnings of code words, said synchronizing step including determining the beginning of a code word by finding at least one of the following in the encoded data:

A. a single bit pattern of a ONE in an odd bit position followed by three ZEROS;

B. a ONE in an odd bit position followed by four or more ZEROS;

C. a bit pattern 00000100 starting at an odd bit position; or

D. a bit pattern 01000100 starting at an odd bit position.

33. The demodulating method of claim 32, wherein said synchronizing step further includes:

A. finding in the encoded data a repeated bit pattern of 0001 with the ONE in an odd bit position;

B. shifting two bit positions such that the repeated pattern is interpreted as 0100; and

C. finding in the shifted data a ONE in a predetermined bit position or a predetermined pattern signifying the beginning of a code word.

34. The demodulating method of claim 33, wherein said method includes the step of determining the end of a code word by finding in the encoded data a ONE in an even bit position.

35. A method of synchronizing a demodulator to data encoded by the following code:

| DATA BITS | CODE WORDS |
|---|---|
| 00 | 000X |
| 01 | 0100 |
| 10 | 100X |
| 011 | 10000X |
| 111 | 100100 |
| 0000 | 1000000X |

where X is a ONE if the last two bits of the preceding code word are both ZEROS and X is a ZERO otherwise, and the right-most bits of the data and the code words are the first in time, said method including the step of determining the beginnings of code words by finding at least one of the following in the encoded data:

A. a single bit pattern of a ONE in an odd bit position followed by three ZEROS;

B. a ONE in an odd bit position followed by four or more ZEROS;

C. a bit pattern 00000100 starting at an odd bit position; or

D. a bit pattern 01000100 starting at an odd bit position.

36. The synchronizing method of claim 35, wherein said step of determining the beginnings of code words further includes:

A. finding in the encoded data a repeated bit pattern of 0001 with the ONE in an odd bit position;

B. shifting two bit positions such that the repeated pattern is interpreted as 0100; and

C. finding in the shifted data a ONE in a predetermined bit position followed by a predetermined bit pattern or a predetermined bit pattern signifying the beginning of a code word.

37. The synchronizing method of claim 36, wherein said method further includes the step of determining the end of a code word by finding in the encoded data a ONE in an even bit position.

38. A method of synchronizing a demodulator to data encoded by the following code:

| DATA BITS | CODE WORDS |
|---|---|
| 00 | 000X |
| 01 | 0100 |
| 10 | 100X |
| 011 | 10000X |
| 111 | 100100 |
| 0000 | 10000001 |

where X is a ONE if the last two bits of the preceding code word are both ZEROS and X is a ZERO otherwise, and the right-most bits of the data and the code words are the first in time, said method including the step of determining the beginnings of code words by finding at least one of the following in the encoded data:

A. a single bit pattern of a ONE in an odd bit position followed by three ZEROS;

B. a ONE in an odd bit position followed by four or more ZEROS;

C. a bit pattern 00000100 starting at an odd bit position; or

D. a bit pattern 01000100 starting at an odd bit position.

39. The synchronizing method of claim 38, wherein said step of determining the beginnings of code words further includes:

A. finding in the encoded data a repeated bit pattern of 0001 with the ONE in an odd bit position;

B. shifting two bit positions such that the repeated pattern is interpreted as 0100; and

C. finding in the shifted data a ONE in a predetermined bit position followed by a predetermined bit pattern or a predetermined bit pattern signifying the beginning of a code word.

40. The synchronizing method of claim 39, wherein said method further includes the step of determining the end of a code word by finding in the encoded data a ONE in an even bit position.

41. A synchronizing system for synchronizing a demodulator to data encoded by the following code:

| DATA BITS | CODE WORDS |
|---|---|
| 00 | 000X |
| 01 | 0100 |
| 10 | 100X |
| 011 | 10000X |
| 111 | 100100 |
| 0000 | 1000000X |

where X is a ONE if the last two bits of the preceding code word are both ZEROS and X is a ZERO otherwise, and the right-most bits of the data and the code words are the first in time, said system including means for determining the beginnings of code words by finding at least one of the following in the encoded data:

A. a single bit pattern of a ONE in an odd bit position followed by three ZEROS;

B. a ONE in an odd bit position followed by four or more ZEROS;

C. a bit pattern 00000100 starting at an odd bit position; or

D. a bit pattern 01000100 starting at an odd bit position.

42. The synchronizing system of claim 41, wherein said means for determining the beginnings of code words includes:

A. finding in the encoded data a repeated bit pattern of 0001 with the ONE in an odd bit position;

B. means for shifting two bit positions such that the repeated pattern is interpreted as 0100; said means for determining the beginnings of code words finding in the shifted data a ONE in a predetermined bit position followed by a predetermined bit pattern or a predetermined bit pattern signifying the beginning of a code word.

43. The synchronizing system of claim 42, wherein said system further includes means for determining the end of a code word by finding in the encoded data a ONE in an even bit position.

44. A synchronizing system for synchronizing a demodulator to data encoded by the following code:

| DATA BITS | CODE WORDS |
|-----------|------------|
| 00 | 000X |
| 01 | 0100 |
| 10 | 100X |
| 011 | 10000X |
| 111 | 100100 |
| 0000 | 10000001 |

where X is a ONE if the last two bits of the preceding code word are both ZEROS and X is a ZERO otherwise, and the right-most bits of the data and the code words are the first in time, said system including means for determining the beginnings of code words by finding at least one of the following in the encoded data:

A. a single bit pattern of a ONE in an odd bit position followed by three ZEROS;

B. a ONE in an odd bit position followed by four or more ZEROS;

C. a bit pattern 00000100 starting at an odd bit position; or

D. a bit pattern 01000100 starting at an odd bit position.

45. The synchronizing system of claim 44, wherein said means for determining the beginnings of code words includes:

A. finding in the encoded data a repeated bit pattern of 0001 with the ONE in an odd bit position;

B. means for shifting two bit positions such that the repeated pattern is interpreted as 0100; said means for determining the beginnings of code words finding in the shifted data a ONE in a predetermined bit position followed by a predetermined bit pattern or a predetermined bit pattern signifying the beginning of a code word.

46. The synchronizing system of claim 44, wherein said system further includes means for determining the end of a code word by finding in the encoded data a ONE in an even bit position.

FIG. I

EP 0 405 836 A2

EXAMINE THE NEXT
FOUR DATA BITS `20`

ARE THE FOUR BITS
ALL ZEROES? `22`

—YES—

ARE THE LAST
TWO BITS OF
THE PRECEDING
CODE WORD 01? `28`

NO

ARE THE FIRST TWO
BITS BOTH ONES? `24` —————YES—

NO

ARE THE LAST
TWO BITS OF
THE PRECEDING
CODEWORD 00? `30`

ENCODE THE FIRST
TWO BITS ACCORDING
TO CODEWORD CHART 1 `26`

ENCODE THE
FIRST THREE
BITS ACCORDING
TO CODEWORD
CHART 1 `36`

YES `32`

ENCODE THE
FOUR BITS TO
THE 8-BIT
CODEWORD
10000001

ENCODE THE FOUR BITS
TO THE 8-BIT CODEWORD
10000000 `34`

STORE A COPY OF THE LAST
TWO BITS OF THE CODEWORD `38`

APPLY THE CODEWORD
TO THE DISK DRIVE `40`

FIG. 2

RETRIEVE CODEWORDS
FROM STORAGE — 42

SET THE FIRST TWO BITS
OF THE RETRIEVED CODE-
WORDS TO ZEROES — 44

YES

DO THE FIRST EIGHT BITS
FORM A VALID CODEWORD? — 46

DECODE THE EIGHT
BITS TO FOUR
DATA ZEROES — 54

NO

DO THE FIRST SIX BITS
FORM A VALID CODEWORD? — 48

YES

58

DECODE THE SIX
TO THREE DATA
BITS ACCORDING
TO CHART 1

NO

56

DECODE
THE FOUR
BITS TO TWO
DATA BITS
ACCORDING TO
CHART 1

YES

DO THE FIRST FOUR BITS
FORM A VALID CODEWORD? — 50

NO

DECLARE AN ERROR IN THE
FIRST TWO DATA BITS — 52

GO TO STEP 42

# FIG. 3